# EUROPEAN PATENT APPLICATION

(11) **EP 1 669 844 A2**
(43) Date of publication of application: **14.06.2006**
(21) Application number: 05024588.5
(22) Date of filing: 10.11.2005
(51) Int. Cl.: G06F 3/033, G08C 17/00, H04B 1/20

(54) **Remote control with touchpad and method**

(30) Priority: 07.12.2004 US 6846
(71) Applicant: Hewlett-Packard Development Company, L.P., Houston, TX 77070 (US)
(72) Inventor: Skinner, David Norton, Redwood Shores California 94065 (US)
(74) Representative: Schoppe, Fritz

(57) **Abstract**

A remote control (10) facilitates the visual indication of the position of an instrument on a touchpad (18) by an external display device (70). The remote control includes a touchpad (18) that produces a signal responsive to being touched by an instrument, a decoder (38) that decodes the signal and that provides a position signal indicating instrument position on the touchpad, and a transmitter (32) that transmits a coded signal to an external display device. The coded signal facilitates a visual indication of the instrument touchpad position by the external display device.

## Description

### BACKGROUND OF THE INVENTION

Remote controls are well known for controlling distant equipment. Such equipment may include everything from vacuum cleaners to a television receiver.

If the equipment to be controlled has a display for showing menus or other selectable subject matter, remote controls generally will control an on screen cursor or highlighting with direction keys that move the cursor in a pure X or Y direction. Generally, four such keys are required for left, right, up, and down cursor movement.

While these prior art arrangements have been somewhat successful, they are cumbersome to use. Also, when time is of the essence, moving a cursor in a first direction and then in a second direction can be time consuming. Moving a cursor directly from point "A" to point "B" is impossible. The present invention addresses these issues.

### SUMMARY OF THE INVENTION

In one embodiment of the invention, a remote control comprises a touchpad that produces a signal responsive to being touched by an instrument. The remote control further comprises a decoder that decodes the signal and that provides a position signal indicating instrument position on the touchpad. The remote control further comprises a transmitter that transmits a coded signal to an external display device. The coded signal facilitates a visual indication of the instrument touchpad position by the external display device.

### BRIEF DESCRIPTION OF THE DRAWING

**FIG. 1** is a plan view of a remote control according to one embodiment of the present invention;

**FIG. 2** is a simplified block diagram of a remote control according to an embodiment of the present invention;

**FIG. 3** is a plan view illustrating the use of a remote control according to an embodiment of the present invention; and

**FIG. 4** is a plan view of a display which may be controlled by the remote control of **FIG. 3** according to an embodiment of the present invention.

### DESCRIPTION OF THE INVENTION

In the following detailed description of exemplary embodiments of the invention, reference is made to the accompanying drawings, which form a part hereof. The detailed description and drawings illustrate a specific exemplary embodiments by which the invention may be practiced. This embodiments are described in sufficient detail to enable those skilled in the art to practice the invention. It is understood that other embodiments may be utilized, and other changes may be made, without departing from the spirit or scope of the present invention. The following detailed description Is therefore not to be taken in a limiting sense, and the scope of the present invention is defined by the appended claims.

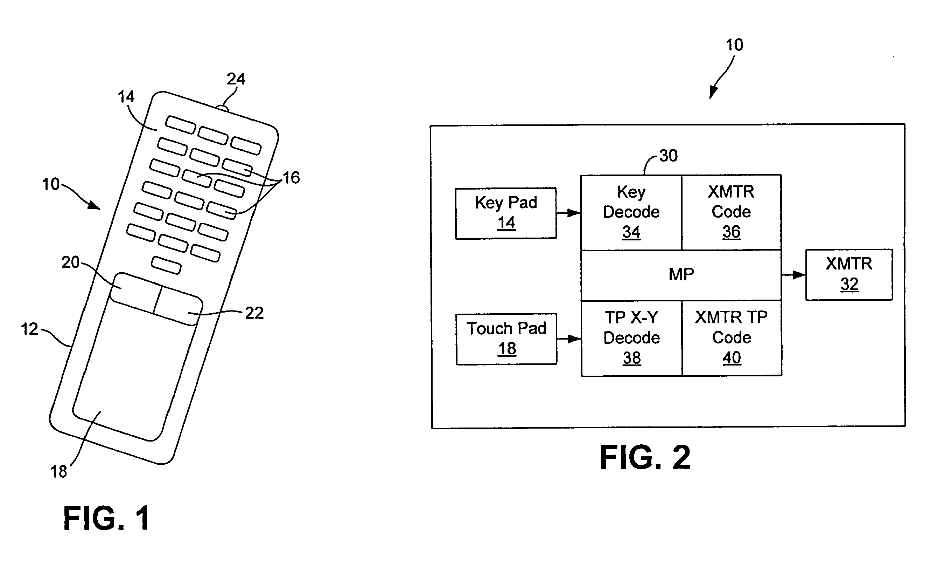

**FIG. 1** illustrates a remote control ***10*** according to an embodiment of the present invention. The remote control ***10*** includes a housing ***12*** which houses internal circuitry of the remote control ***10.*** The remote control also includes a keypad ***14*** including a plurality of keys ***16***. The remote control ***10*** still further includes, and according to this embodiment of the invention, a touchpad 18 and selection keys ***20*** and ***22.***

The keypad ***14*** is provided to function in a manner as well known in the art. Each key of the keypad ***14*** corresponds to a different function to be commanded of the external equipment to be controlled by the remote control ***10***. Preferably, the external equipment includes a display device for displaying menus and other selectable subject matter. When a key of the keypad ***14*** is depressed, a transmitter within the remote control ***10*** transmits a coded signal to the distant equipment which receives the coded signal, decodes the coded signal, and actuates the function corresponding to the key depressed. The transmitter of the remote control ***10*** may be, for example, an infra-red transmitter which utilizes an infra-red LED ***24*** as a transmission element.

The touchpad ***18*** may be provided to the remote control **10** to enable movement of a cursor on the distant equipment display. The touchpad ***18*** may be of a type well known in the art for moving a cursor along a straight line or other line as determined by the movement of an instrument being placed on or brought into close proximity with the touchpad ***18*.** The selection keys ***20*** and ***22*** may be employed for selecting menu items which correspond to given locations on the touchpad.

By virtue of the touchpad ***18,*** according to this embodiment, a cursor may be moved from a first position to a second position on the display screen without having to be moved in a first discreet direction and then in a second discreet direction. Hence, a cursor may be moved along a straight or otherwise continuous path from a first point to a second point by moving an instrument, such as a human finger, along the touchpad ***18*.**

**FIG. 2** shows a simplified block diagram of the remote control ***10*** of **FIG. 1.** As will be noted in **FIG. 2**, the keypad ***14*** and touchpad ***18*** are coupled to a microprocessor ***30***. The microprocessor ***30*** is coupled to a transmitter ***32*** which may be, as previously explained, an infra-red transmitter. However, as will be appreciated by those skilled in the art, the transmitter ***32*** may alternatively be a radio frequency (RF) transmitter.

The microprocessor ***30*** may be programmed to provide functionality of a key decoder ***34*,** a transmitter coder ***36*,** a touchpad X-Y decoder ***38*.** and a transmitter touchpad coder ***40*.**

The key decoder ***34*** determines which one of the keys ***16*** is being depressed. Once the key decoder ***34*** determines which key is depressed, the transmitter coder ***36*** then generates a unique pulse code corresponding to the particular depressed key. The generated pulse code signal is then provided to the transmitter ***32*** which transmits the coded signal to the external device to be controlled.

Infra-red (IR) signals for use with remote controls are well known. IR remote controls may transmit pulses of IR light to a receiver of the equipment to be controlled. Light emitting diodes may be utilized to transmit the IR light in a frequency range of, for example, 30 kHz - 40 Khz. These frequencies are chosen so that other light sources would not interfere with the ability to correctly receive the coded transmitted signals. The coded signals are transmitted in some type of binary code. The binary signal may vary in length for both time and bit length.

There are generally three different ways that these signals may be coded. This coding is usually based on varying the length of the pulses, varying the length of the spaces between the pulses, or altering the order between spaces or pulses. Accordingly, one form of code produces pulse-width-coded signals wherein the length of the pulses is varied to code the information. For example, if the pulse width is short, it corresponds to a logical 0. If, however, the pulse width is long, it corresponds to a logical 1. Another form of coding provides space-coded signals where the length of the spaces between the pulses is varied to code the information. In this case, if the space width is short, it may correspond to a logical 0. However, if the space width is long, for example, it corresponds to a logical 1. A last form of coding provides shift-coded signals where the order of the pulse space is varied to code the information. In this case, if the space width is short and the pulse width is long, for example, the signal corresponds to a logical 1. However, if the space is long and the pulse is short, the signal may correspond to a logical 0.

The coded signals are sent according to a known protocol. This protocol may Include, for example, information such as the address to the equipment that is using the remote and the command that the equipment must follow. The address is very important because, without it, the signal would be processed by another IR receiver in the area. When a button on the remote is pushed, it sends a string of signals. The first piece of information in the string is called the header. The header usually contains a burst of highs that alerts all of the IR receivers in the area to the string of data being sent. Following the burst of highs is the address to the specific equipment to receive the next piece of data, the command. As long as the button is held down (depressed) the command will continue to repeat over and over. When the button is released, a string of code called the stop is transmitted. As one may guess, the stop tells the equipment to stop its executing the commanded function.

The touchpad ***18*** may be of the type which utilizes capacitive position sensing technology. Capacitive position sensing works by sensing an electrical phenomenon called capacitance. Whenever two electrically conductive objects come near to each other without touching, their electric fields interact to form capacitance. The surface of the touchpad ***18*** may be a grid of conductive metal wires covered by an insulator. The human finger is also an electrical conductor. When the finger is placed on the touchpad, a tiny capacitance forms between the finger and the metal wires in the touchpad. The insulator keeps the finger from actually touching the wires and may be textured to help the finger move smoothly across the surface of the touchpad.

Electronics, known in the art, can measure the amount of capacitance in each of the wires. When the capacitance increases, the touchpad can tell when the finger is touching it. By determining which wires have the most capacitance, the touchpad can also locate where the finger is on the touchpad to a high degree of accuracy. The sensing electronics may be the touchpad X-Y decoder ***38*** of the microprocessor ***30*** or alternatively, may be in an application specific integrated circuit of the touchpad ***18*.** The application specific integrated circuit or the touchpad X-Y decoder ***38*** may compute the position of the finger on the touchpad along with the speed in which the finger Is moving. The position signal thus produced by the transmitter touchpad coder ***40*** is thus a coded signal indicative of the position of the finger on the touchpad. The touchpad, touchpad X-Y decoder ***38*,** and the transmitter touchpad coder ***40*** may continuously generate position indicative signals as long as the finger or other instrument is moving across the touchpad. The signals thus produced are transmitted by the transmitter ***32*** for receipt by the distant equipment to be controlled. The signals may be utilized for moving a cursor on a display for performing, for example, menu selection or menu scrolling.

In view of the foregoing, it can be seen that a position dependent signal may be continuously produced as long as an instrument, such as a finger, is moved along the touchpad ***18*.** This may be utilized for moving a cursor from a first point to a second point without having to move the cursor in discrete X and Y directions.

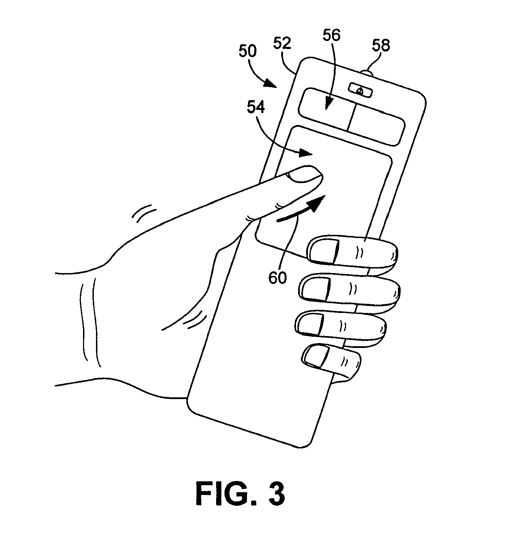

**FIG. 3** shows a remote control ***50*** according to an embodiment of the present invention in use. The remote control includes a housing ***52*,** a touchpad ***54*,** a menu selection switch 56, and an infra-red transmitting element ***58*.** Here it may be seen that the thumb of a hand is used to swipe the touchpad ***54*** In the direction of an arrow ***60*.** In a manner as previously described with respect to **FIG. 2,** the remote control ***50*** will transmit a continuously changing position dependent coded signal corresponding to, at any one time, the instantaneous position of the thumb on the touchpad ***54*;**

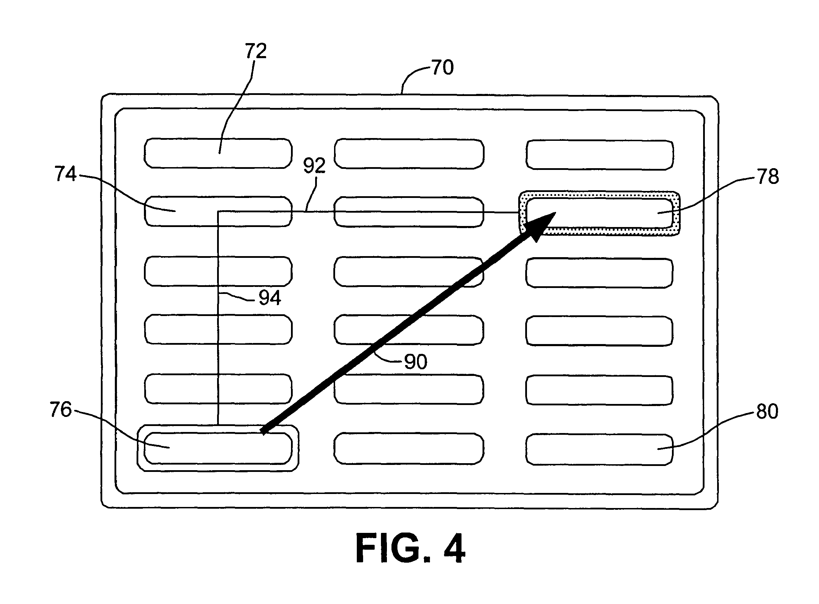

As may be seen in **FIG. 4,** a display ***70*** includes a plurality of selectable menu options, as, for example, menu options ***72*, *74*, *76*, *78*,** and ***80*** as well as other menu options not specifically numerated. As will be noted in **FIG. 4,** highlighting on the display ***70*** is moved from a menu option ***76*** directly to a menu option ***78*** along arrow ***90*** which corresponds to arrow ***60*** of **FIG. 3.** Hence, menu selection directly from menu option ***76*** to menu option ***78*** is rendered possible by employment of the touchpad ***54*** on the remote control ***50*** of **FIG. 3.** This is in direct contrast to the discrete X ***92*** and Y ***94*** cursor or highlighting of movement previously required by the prior art.

When the menu option ***78*** Is highlighted by the thumb being over it's corresponding position on the thumb pad, the selection switch ***56*** may be depressed to facilitate selection of menu option ***78*.** Other menu options may be selected in a similar manner.

While capacitive position sensing touchpads have been generally described herein, other forms of touchpads may also be utilized without departing from the present invention. For example, touchpads utilizing membrane switch technology or resistive sensor technology, may be alternatively employed without departing from the present invention.

Although the present invention has been described in considerable detail with reference to certain preferred embodiments, other embodiments are possible. Therefore, the spirit or scope of the appended claims should not be limited to the description of the embodiments contained therein. It is intended that the invention resides in the claims.

## Claims

1. A remote control **characterized by**:
a touchpad (18) that produces a signal responsive to being touched by an instrument;
a decoder (38) that decodes the signal and that provides a position signal indicating instrument position on the touchpad; and
a transmitter (32) that transmits a coded signal to an external display device, the coded signal facilitating a visual indication of the instrument touched position by the external display device.

2. The remote control of claim 1 further **characterized by** the remote control including at least one key switch (20) that enables menu selection corresponding to instrument touchpad position.

3. The remote control of claims 1 or 2 further **characterized by** the transmitter continuously transmitting the coded signal responsive to movement of the instrument across the touchpad.

4. The remote control of claims 1, 2, or 3 further **characterized by** the decoder comprising a processor (30).

5. The remote control of claims 1, 2, 3, or 4 further **characterized by** a coder (40) that provides the transmitter with the coded signal responsive to the position signal.

6. The remote control of claim 5 further **characterized by** the coder comprising a processor (30).

7. The remote control of claims 1, 2, 3, 4, 5, or 6 further **characterized by** the transmitter being an infra-red transmitter.

8. The remote control of claims 1, 2, 3, 4, 5, 6, or 7 further **characterized by** the transmitter being a radio frequency transmitter.

9. A method comprising:
receiving a touchpad signal;
decoding the touchpad signal to provide a position dependent signal;
generating a coded position indicating signal response to the position dependent signal; and
transmitting the position indicating signal to a display device.

10. The method of claim 9 further **characterized by** the transmitting step including continuously transmitting the position indicating signal as long as the position dependent signal is changing.
